Europäisches Patentamt

European Patent Office

Office européen des brevets

(11) Publication number: **0 414 393 A1**

# EUROPEAN PATENT APPLICATION

(21) Application number: 90308484.6

(22) Date of filing: 01.08.90

(51) Int. Cl.5: **H01R 23/70**

(30) Priority: 23.08.89 GB 8919167

(43) Date of publication of application:
27.02.91 Bulletin 91/09

(84) Designated Contracting States:
DE ES FR GB IT SE

(71) Applicant: ITT INDUSTRIES LIMITED
Jays Close, Viables Estate, Basingstoke
Hampshire RG22 4BW(GB)

(72) Inventor: Collier, John Covell
9 Howard Court, Albert Road
Southport, Merseyside PR9 9LN(GB)
Inventor: Lee, David
9 Whitlow Avenue, Goldbourne
Warrington, Cheshire(GB)

(74) Representative: Vaufrouard, John Charles et
al
Ruffhead & Vaufrouard Maidstone Road
(STC Site) Foots Cray
Sidcup Kent DA14 5HT(GB)

(54) Improvements relating to electrical connectors.

(57) An electrical connecting arrangement is provided between an electrical edge connector and a printed circuit board in which contact pads provided near the edge of the printed circuit board have a convex profile at least in the direction of insertion of the board into an opening in the edge connector. The depth of the connector opening and the distance of the contact pads from the board edge is such that during insertion of the board into the connector contact springs of the latter ride up and over the convex profile of the pads and come to rest beyond the centre line of the convex profile when the board is fully inserted.

*Fig. 1.*

## IMPROVEMENTS RELATING TO ELECTRICAL CONNECTORS

This invention relates to electrical connectors and relates more specifically to electrical edge connectors for making electrical connections to printed circuit or wiring boards by the engagement of spring contacts of the edge connector with contact elements provided on the printed circuit boards. The contact elements referred conventionally comprise a group of thin conductive strips extending in parallel relationship from the edge of the printed circuit board. It is common practice to plate these conductive strips and those parts of the spring contacts of the edge connector which make contact therewith with precious metal (e.g. gold) in order to avoid contact oxidation problems. However, this conventional edge connector arrangement suffers from the following disadvantages:

(a) The cut edge of the printed circuit board at which the groups of contact strips terminate tends to bite into and scuff the precious metal plating on the spring contacts of the edge connector as the contacts engage with the foremost ends of the contact strips and any surface debris resulting from such scuffing of the contact plating will tend to build up in front of the spring contacts as they slide over the contact strips and thereby adversely affect the electrical connections between the spring contacts and the contact elements of the printed circuit board.

(b) The contact strips on the printed circuit board tend to be unduly large and thereby occupy valuable board space which could be utilised for accommodating other circuit components. This feature is particularly important in the case of miniaturised circuit boards produced using surface mounting technology.

(c) The regions of contact between the spring contacts of the connector and the strip contact elements on the boards are such that the Hertz stress tends to be undesirably low for optimum electrical connections between the contacts.

(d) The relatively high forces which are sometimes required for insertion of the printed circuit board into the edge connector, more particularly in the case of edge connectors having large numbers of spring contacts make it difficult to determine when the connector is fully engaged with the board contacts.

It has already been proposed in U.K. Patent No. 2179578B to replace the conventional contact strips along the edge of the printed circuit board with suitably positioned relatively small contact pads, preferably dome-shaped, attached to the board at a short distance from its edge and engaged by the spring contacts of the edge connector. This contact arrangement enables some of the aforesaid disadvantages of the conventional edge connector to be overcome. Moreover, the problem of wear on the spring contact where it makes engagement with the strip contact on the board as the latter is inserted into the connector is avoided.

The present invention is directed to further improvements in the contact pad arrangement disclosed in the above-mentioned patent.

According to a first aspect of the present invention there is provided an electrical connecting arrangement between a printed circuit/wiring board and an edge connector having an insulating body accommodating a plurality of spring contacts for making contact with contact elements located on the printed circuit/wiring board, in which the contact elements on the printed circuit/wiring board define contact pads which are spaced from an edge of the board adapted for insertion into the edge connector and which are formed with a convex profile at least in the direction of insertion of the board into the edge connector and in which the depth of an opening in the connector for receiving the board edge and the distance of the contact pads from the board edge is such that during insertion of the board into the connector the contact springs ride up and over the convex profile and come to rest on a part of the contact pad beyond the centre line of the convex profile when the board is fully inserted.

By the connecting arrangement according to the above aspect of the present invention not only is the aforesaid scuffing of the spring contact plating material by engagement with the sharp edges of the contact strips of the circuit board avoided but the mutual areas of contact pressure engagement between the spring contacts and the contact pads on the printed circuit board when the edge connector is fully engaged with the board are areas which are not subjected to wear during insertion and withdrawal of the board from the edge connector. Moreover, the spring forces exerted on the contact pads by the edge connector spring contacts tend to produce accelerated movement of the printed circuit board into the edge connector as the spring contacts move beyond the centre lines of the convex profiles of the contact pads. This feature not only has the advantage of assisting full engagement between the edge connector and the circuit board but it may be utilised to provide a positive snap action connection between the board and the connector, thereby positively eliminating any uncertainty as to whether the board and connector are fully engaged.

According to one preferred embodiment of the present invention the spring contacts are shaped so that the angle of the spring contact part that first makes contact with a contact pad is less steeply inclined relative to the direction of insertion of the board into the edge connector than is that part of the spring contact which finally comes to rest on the contact pad. This feature provides for ease of full insertion of the board into the edge connector whilst producing higher board retention forces.

In carrying out the present invention the contact pads ' are preferably dome-shaped thereby providing optimum Hertz stress but other configurations of contact pad may be utilised without departing from the principle or spirit of the invention. For example, they may be semi-cylindrical or the pads may have a tapered/inclined foremost section and a generally semi-cylindrical rearmost end.

The spring contacts and/or contact pads may be gold plated over those parts which make pressure engagement or the contacts may be plated with a tin alloy, for example.

According to a second aspect of the present invention an electrical edge connector for receiving a printed circuit or wiring board comprises an insulating body with a board-receiving opening therein which contains an abutment for engagement by the board edge when fully inserted into the connector, in which the abutment is adapted to restrain the board against movement thereof in directions other than that of withdrawal from the connector in order to provide a highly stable connector/board assembly thereby preventing relative movement between the usual co-operating contacts of the edge connector and board when the latter are in full engagement.

This highly stable assembly will prevent relative movement between the cooperating contacts when exposed to small amplitude vibration conditions that have caused so-called "fretting corrosion" failures on tin/lead plated contacts of printed circuit/edge connectors hitherto. Since failures occurred, for example, in television sets and electronic organs, due to the small amplitude vibrations generated by the loudspeakers of such equipment.

In carrying out this aspect of the invention the abutment may be provided with a groove or channel which receives the edge of the board, the groove or channel being V-shaped or semi-cylindrical, for example.

When this aspect of the invention is utilised with the first aspect of the invention of providing contact pads on the printed board, the stability of the assembly may be further enhanced by spacing the contact pads further from the board edge than would otherwise be necessary.

According to a third aspect of the present invention there is provided a method of attaching contact pads having a curved profile to a printed circuit board, preferably at positions relative to the edge of the printed circuit board facilitating the provision of the electrical connecting arrangement according to the first aspect of this invention, in which the printed circuit board is provided with a plurality of conductive regions to which conductive bonding material is applied at positions at which the contact pads are to be secured to the board and in which the contact pads are accurately positioned relative to the conductive areas and the bonded material is melted or otherwise activated and caused to become re-solidified to cause bonding of the contact pads to the printed circuit board. A printed circuit board provided with contact pads according to this third aspect of the present invention may also be used with the edge connector constructed in accordance with the second aspect of this invention.

The bonding material may comprise solder paste which may, in the case of miniaturised surface mounted boards be applied to the conductive regions of the board by silk screening. The adhesion of such contact pads to the boards will be appreciably better than that between the conventional contact strips provided at the edge of the board in the case of the previously described conventional printed board/edge connector arrangement.

It may here be mentioned that in carrying out either this third aspect of the invention or the first aspect the contact pads may be produced simply by pressing or stamping the pads from a sheet of suitable material (e.g. phosphor bronze). The action of the press tool may itself produce a sufficiently convex profile for the contact pads in the case of dome-shaped pads.

The general base shape of the contact pads may be circular or rectangular and in the case when solder (e.g. solder paste) is used as the bonding material the precise location of the pads on the underlying conductive regions of the board which will be of corresponding shape and dimensions will be achieved by solder re-flow alignment resulting from the surface tension produced in the molten solder during the solder re-flow procedure.

The positioning of the contact pads on the printed circuit boards may conveniently be achieved by the use of a "pick and place" mechanism conventionally used in surface mounting technology for the positioning of components on the board prior to bonding thereof to the board.

Irrespective of whether the first and/or second aspects of this invention are implemented the contact pads may be provided on one or both sides of the printed circuit board according to the spring contact arrangement of the edge connector. The contact pads may also be arranged in a single row on one or both sides of the board at a predetermined distance from the edge of the board or a plurality of rows may effectively be provided on one or both sides of the board by staggering alternate contact pads in the direction of engagement of the board with the edge connector. With this staggered contact pad arrangement the tracking distance between adjacent contacts is increased.

By way of example the present invention will now be described with reference to the accompanying drawings in which:

Figure 1 shows a transverse sectional view through an edge connector illustrating the engagement of spring contacts of the connector with contact elements of a printed circuit board;

Figures 2 and 3 are views similar to that of Figure 1 but illustrating preferred embodiments of the invention;

Figure 4 shows a transverse cross-sectional view similar to that of Figure 1, but in which the spring contacts of the edge connector and contact pads of the printed circuit board are staggered relative to the direction of engagement of the board with the edge connector;

Figure 5 shows a view similar to that of Figure 4 but illustrating a preferred embodiment of staggered contact edge connector/printed board arrangement.

Figure 6 shows various examples of contact pad profiles for use in the Figure 1 to Figure 5 arrangements and,

Figures 7(a) to 7(d) illustrate different contact pad arrangements for printed circuit boards.

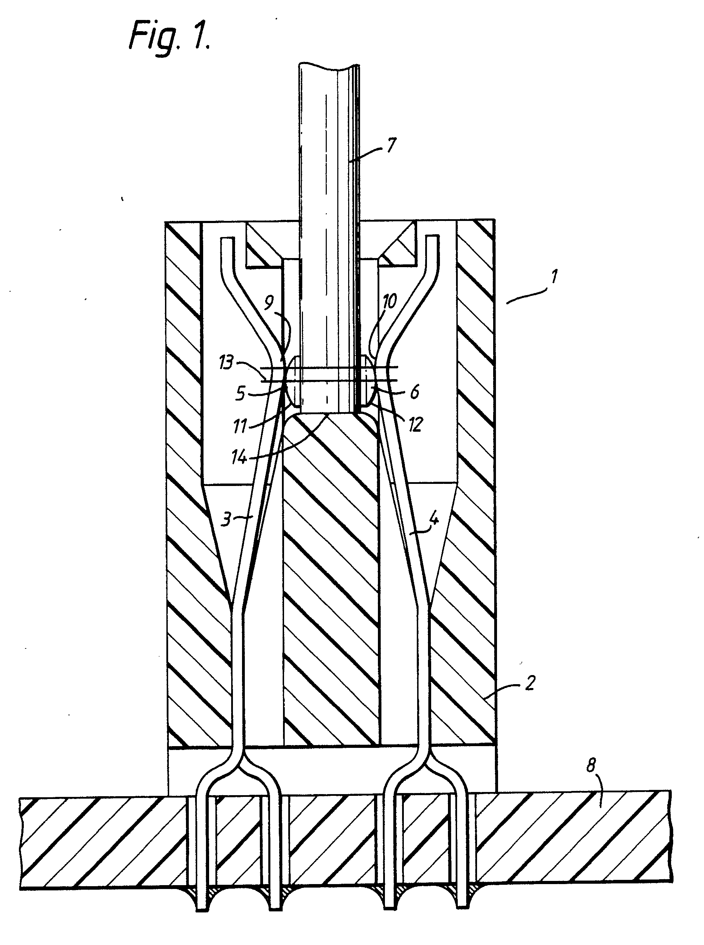

Referring to Figure 1 of the drawings, this shows an edge connector 1 the insulating body of which is shown in cross section at 2 having accommodated within internal cavities along the length of the body a multiplicity of spring contacts, such as the spring contacts 3 and 4. In the present embodiment the spring contacts of the edge connector are arranged in two sets for co-operating with contacts, such as the contacts 5 and 6, provided on the respective sides of a printed circuit board 7. However, the edge connector could alternatively be provided with a single set of spring contacts for co-operation with contact pads provided on one side only of the printed circuit board. The edge connector is mounted on a circuit board 8 (e.g. back-plane assembly board) by the soldering of the spring contacts 3 and 4 to conductive channels of the board 8.

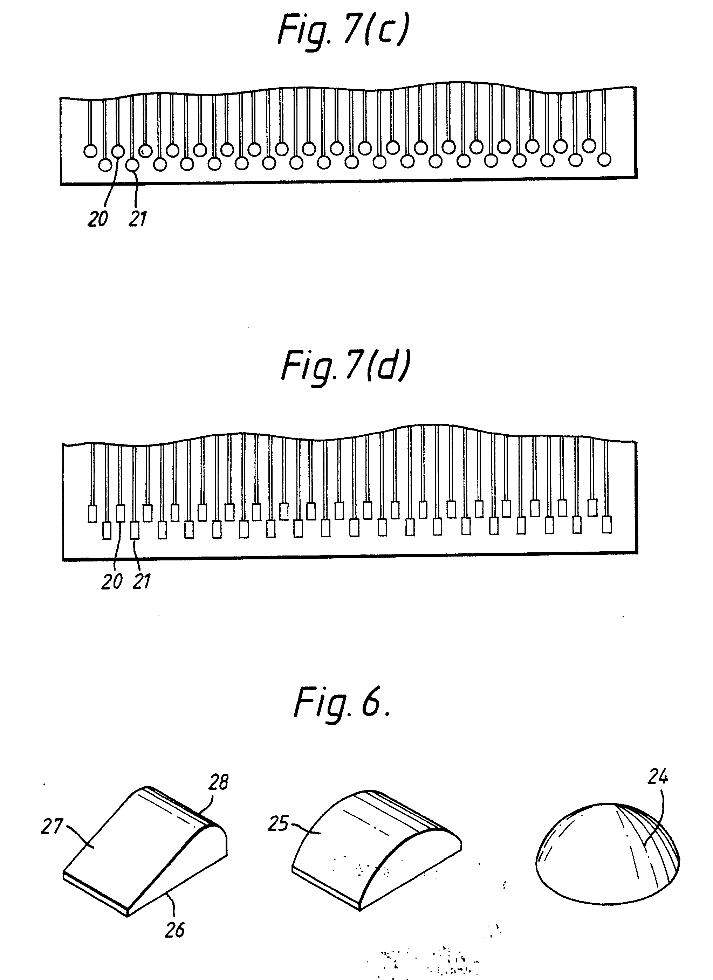

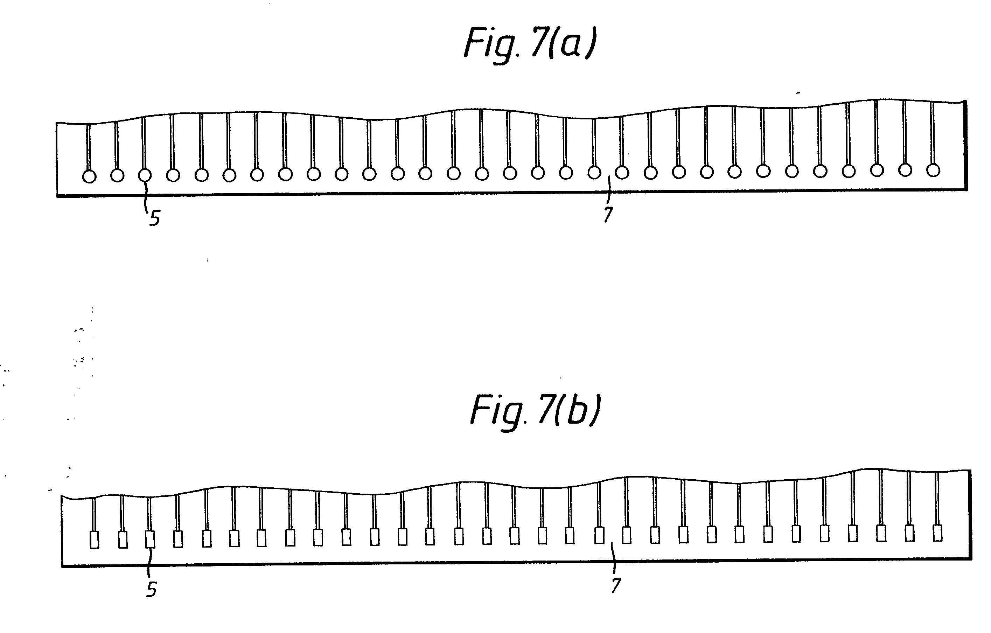

As will be appreciated from Figure 7(a) and 7-(b), the contact pads 5 and 6 will be contained within rows of contact pads provided on opposite sides of the board 7 and accurately spaced in from the edge of the board 7.

In accordance with the present invention the contact pads, such as the contact pads 5 and 6, have a convex profile in the direction of insertion of the board 7 into the edge connector 1.

As will be appreciated from Figure 1, as the edge connector receives the edge of the printed circuit board 7 the contact pads 5 and 6 which are preferably dome-shaped are first engaged by the curved sections 9 and 10 of the spring contacts 5 and 6 at about the small areas or points 11 and 12 on the contact pads thereby concentrating the spring contact pressure exerted by the spring contacts at the points of mutual engagement between the contacts to provide optimum Hertz stress at these points. As the spring contacts 3 and 4 ride over the spherical surface of the contact pads 5 and 6 the points of mutual engagement between the contacts will constantly be changing thereby distributing any contact wear over a series of points of mutual engagement. When the spring contacts 3 and 4 ride over the centre line 13 of the dome-shaped contacts 5 and 6 the spring force exerted by the spring contacts 3 and 4 on the contacts 5 and 6 will suddenly assist movement of the edge of the board into the edge connector until the board edge engages with an abutment 14 within the edge connector body 2. The board 7 comes to rest in the connector with the spring contacts 3 and 4 making pressure point engagement with the respective dome-shaped contact pads 5 and 6 and mutual points which, advantageously, are not subject to excessive wear during insertion and withdrawal of the board 7 from the edge connector. Additionally, the transient accelerated movement of the spring contacts through and beyond the centre line of the dome-shaped contact pads towards the end of its travel serves to provide a positive, preferably snap, action indicating full engagement between the board and the connector. This spring force exerted on the contact pads by the spring contact not only provides the requisite electrical connection but also acts in a direction to preserve full engagement between the edge connector 1 and the board 7. This would help to avoid so-called "fretting corrosion" if tin alloy plated contacts were used on the board and/or edge connector.

The profile of the dome-shaped contacts also tends to prevent the build up of any oxide or other debris which may otherwise be shifted forward to the contact rest position by the spring contacts during insertion of the board into the edge connector.

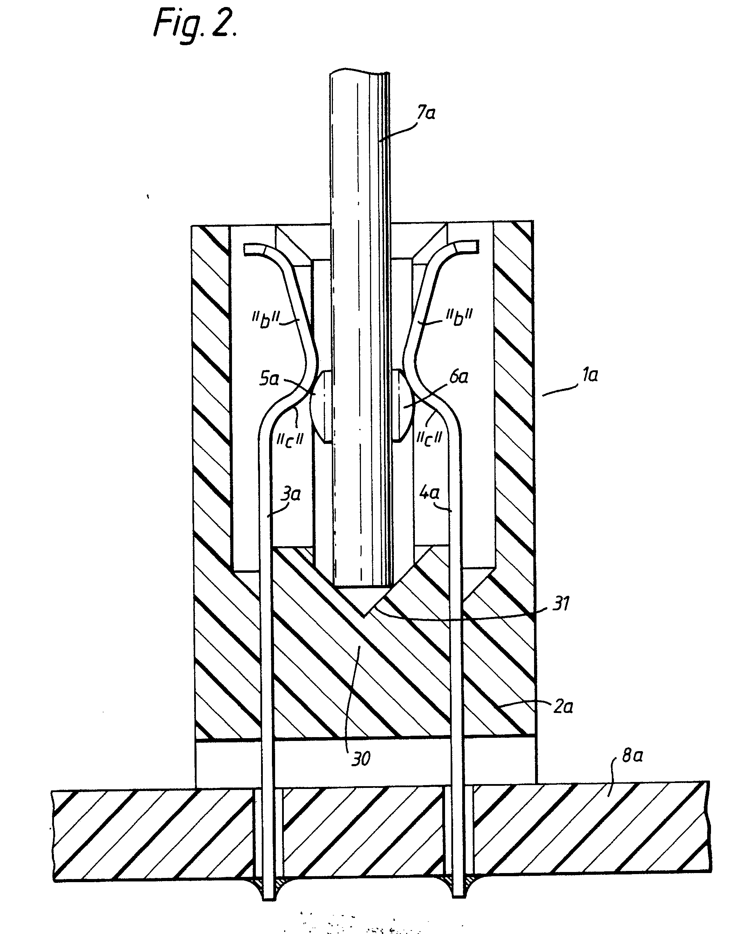

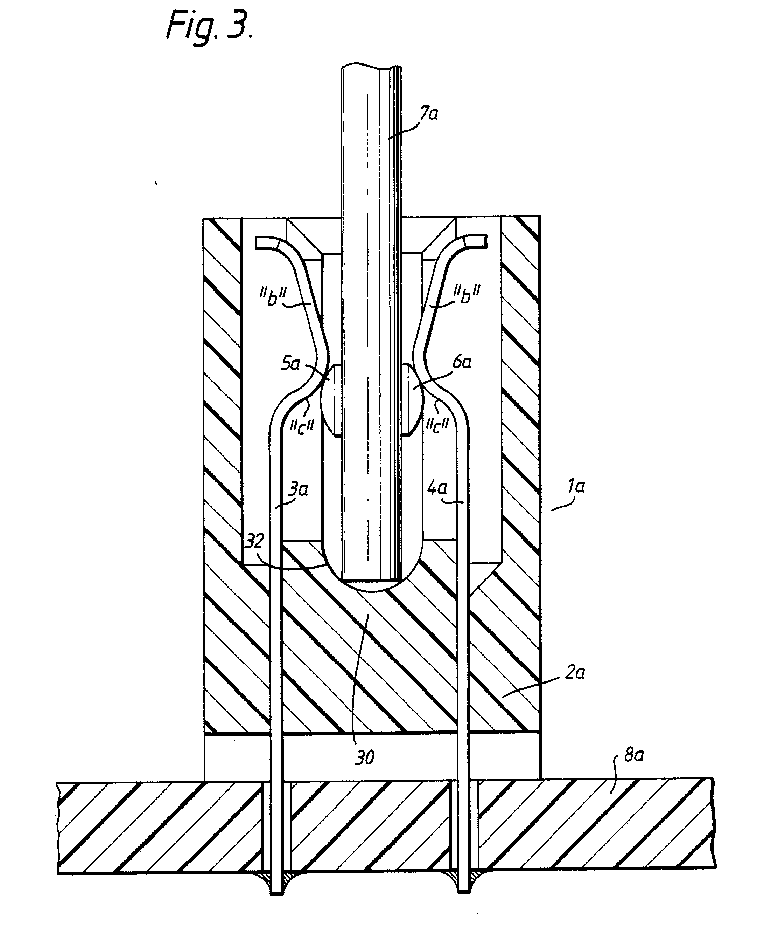

Referring now to Figures 2 and 3 of the drawings these show preferred embodiments of the invention in which spring contacts 3a and 4a of the edge connector 1a having an insulating body 2a have free end portions "b" thereof which are less steeply inclined relative to the direction of insertion of the board 7a into the edge connector than the spring contact portions "c". This arrangement provides for ease of insertion of the board 7a into the edge connector as the less steeply inclined portions "b" of the springs 3a and 4a ride up and over the convex profiles of the respective dome-shaped contact pads 5a and 6a. As the current parts of the springs 3a and 4a pass beyond the centre lines of the dome-shaped pads the more steeply inclined portions "c" of the spring contacts come into engagement with the pads 5a and 6a so that the forces acting at the points of mutual engagement between the spring contacts and the contact pads provide relatively high retention forces for holding the printed board 7a firmly in position with respect to the edge connector 1a as well as resisting withdrawal of the board from the edge connector.

According to the previously mentioned second aspect of the invention the body 2a of the edge connector is provided with an abutment 30 which is provided with a V-shaped groove 31 in the case of Figure 2 and a semi-cylindrical groove or channel 32 in the case of Figure 3. As can be seen, the groove 31 or 32 receives the end of the printed circuit board 7a and serves to restrain the board 7a against lateral movement, thereby preventing relative movement between the connector contacts 3a and 4a and the co-operating board contact pads 5a and 6a under small amplitude vibration conditions which could cause fretting corrosion as previously mentioned. The stability of the arrangement is also enhanced by positioning the contact pads 5 and 6 farther from the edge of the board than in the Figure 1 arrangement.

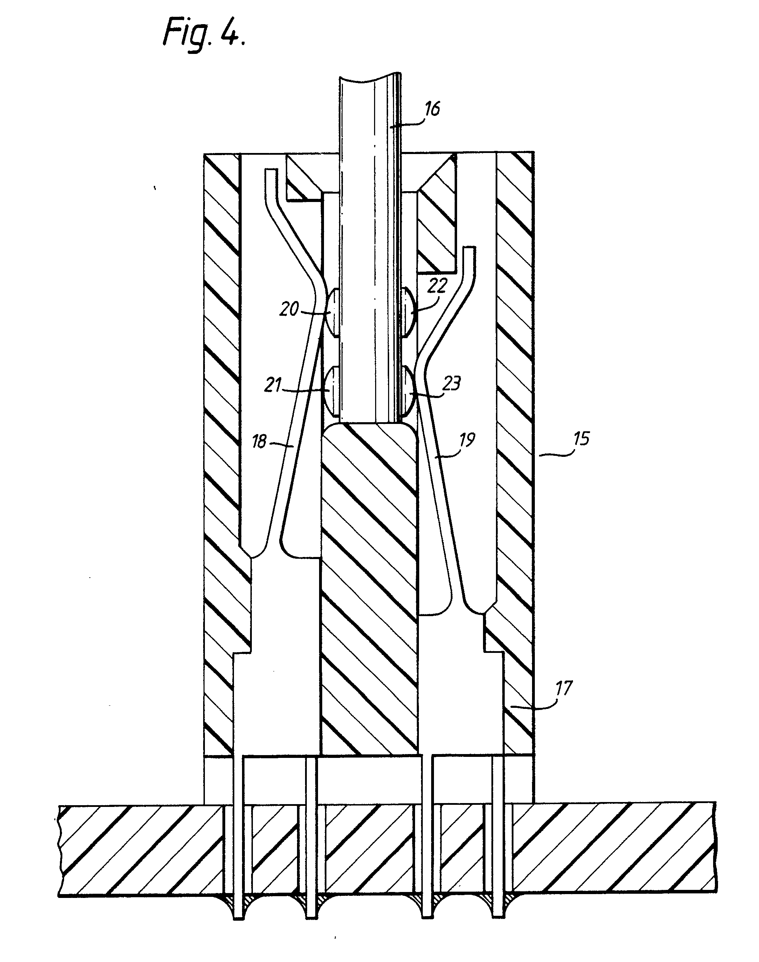

Referring now to Figure 4 of the drawings, this shows an edge connector 15 with a printed circuit board 16 inserted therein in which the connector has an insulating body 17 accommodating along its length two sets of spring contacts containing contacts such as the contacts 18 and 19, the positions of alternate spring contacts being staggered relative to the board receiving end of the connector 15. The board 16 in this case is provided on both sides with rows of contact pads alternate pads of which such as the pads 20 and 21 and the pads 22 and 23 are staggered correspondingly to the staggering of the spring contacts 18 and 19. This arrangement increases the tracking area between adjacent contacts but in other respects the operation is as fully described with reference to Figure 1 of the drawings. The staggered arrangement of the contact pads can readily be appreciated by reference to Figures 7(c) and 7(d).

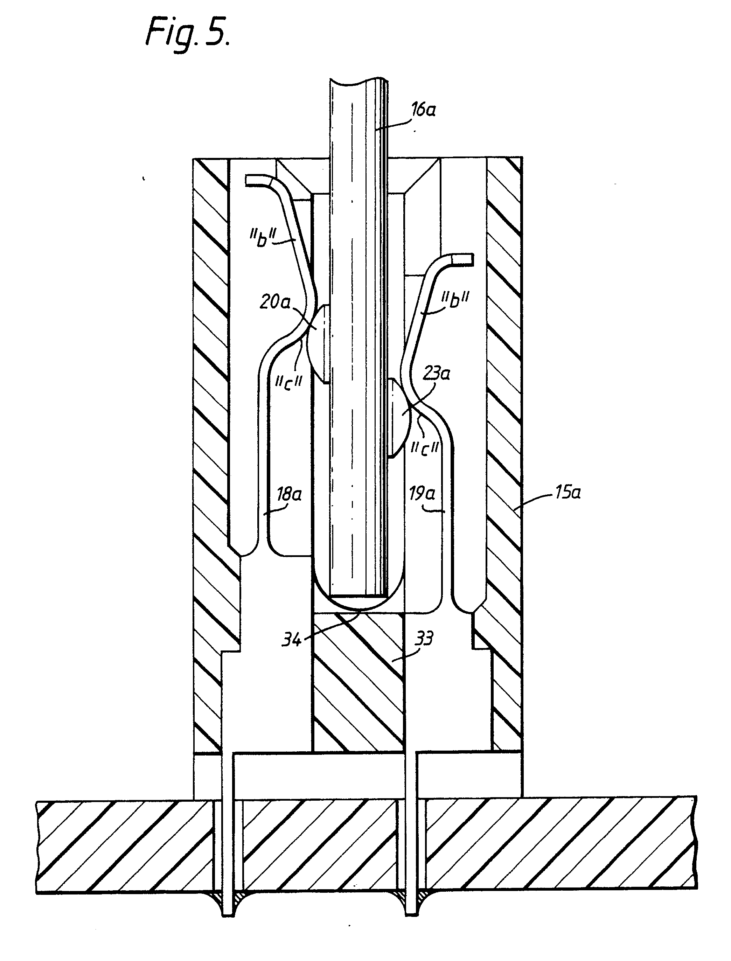

Referring to Figure 5 of the drawings the preferred arrangement illustrated combines the features of Figures 2 and 3 with those of Figure 4. As will be seen the spring contacts 18a and 19a have less steeply inclined portions "b" and more steeply inclined portions "c" which provide for ease of insertion of the board 16a into the edge connector 15a and high retention characteristics.

The body 17a of the connector has an abutment 33 which is provided with a semi-cylindrical groove 34 for receiving the end of the printed board 16a to provide a highly stable assembly as fully described with reference to Figures 2 and 3.

Referring to Figure 6 of the drawings, this shows a dome-shaped pad 24 and alternative forms of convex profile contact pads 25 and 26 which could be substituted for the dome-shaped pads of Figures 1 to 5. As an alternative to the dome-shaped pad 24 the semi-cylindrical pad 25 may be used or the pad 26 which has a leading tapered inclined section 27 and a rearmost semi-cylindrical section 28.

According to a third aspect of the present invention contact pads having a convex profile such as the dome shaped pad 24 the semi-cylindrical pad 25 or the contact pad 26 having a tapered foremost end followed by a semi-cylindrical tail section as shown in Figure 6 may be attached to a printed circuit board by applying solder paste to conductive regions of corresponding shape and corresponding dimensions to the bases of the contact pads. These conductive regions will normally be produced on the board by conventional etching techniques. The solder paste may be applied to the board using silk screening processes after which the contact pads may be positioned on the solder paste to which they will adhere at appropriate locations as by the use of so-called pick and place mechanisms commonly used in surface mounting technology for component positioning purposes. After approximate positioning of the contact pads on the board the solder paste will be melted using solder reflow techniques whereby the surface tension of the molten solder will produce self alignment of the contact pads with respect to the correspondingly shaped correspondingly dimensioned conductive regions on the board for the precise positioning of the contact pads relative to the board.

Boards having contact pads secured thereto in the manner just above described are eminently suitable for use in the board/edge connector electrical connector arrangement according to the first-mentioned aspect of the present invention.

As will be appreciated from the foregoing the present invention provides an advantageous edge connector/printed circuit board connecting arrangement as well as an improved arrangement for the positioning and attachment of contact pads to a printed circuit board which is eminently suitable for use in the aforesaid advantageous board/edge connector connecting arrangement.

Claims

1. An electrical connecting arrangement between a printed circuit/wiring board and an edge connector having an insulating body accommodating a plurality of spring contacts for making contact with contact elements located on the printed circuit/wiring board, characterised in that the contact elements on the printed circuit/wiring board define contact pads which are spaced from an edge of the board adapted for insertion into the edge connector and which are formed with a convex profile at least in the direction of insertion of the board into the edge connector and in that the depth of an opening in the edge connector for receiving the board edge and the distance of the contact pads from said edge is such that during insertion of the board into the connector the contact springs ride over the convex profile of the pad and come to rest on a part of the contact pad beyond the centre line of said convex profile.

2. An electrical connecting arrangement as claimed in claim 1, characterised in that the spring contacts of the edge connector are shaped so that the angle of the spring contact part that first makes contact with a contact pad is less steeply inclined relative to the direction of insertion of the board into the edge connector than that part of the spring contact which finally comes to rest on the contact pad.

3. An electrical connecting arrangement as claimed in claim 1 or claim 2, characterised in that the transitional movement of the spring contact through the centre lines of the convex profiles of the contact pad produces a positive snap action which promotes retention of the printed board in full engagement with the edge connector.

4. An electrical connecting arrangement as claimed in any preceding claim, characterised in that the printed circuit board has one row of contact pads on one or both sides of the board and the edge connector has a corresponding set or two sets of opposed spring contacts.

5. An electrical connecting arrangement as claimed in any of claims 1 to 3, characterised in that the printed circuit board has a row of contact pads on one or both sides of the board with alternate pads being staggered relative to the other pads in the direction of insertion of the board into the edge connector and in that the edge connector has correspondingly one set or two sets of spring contacts, alternate spring contacts of the or each set being staggered relative to other springs in the direction of insertion of the board into the connector.

6. An electrical connecting arrangement as claimed in any preceding claim, characterised in that the contact pads are dome shaped.

7. An electrical connecting arrangement as claimed in any of claims 1 to 5, characterised in that the contact pads are semi-cylindrical.

8. An electrical connecting arrangement as claimed in any of claims 1 to 5, characterised in that the contact pads are semi-cylindrical at their foremost ends and semi-cylindrical at their rearmost end.

9. An electrical connecting arrangement as claimed in any preceding claim, characterised in that the contact pads and/or spring contacts are gold plated.

10. An electrical connecting arrangement as claimed in any of claims 1 to 8, characterised in that the contact pads and/or spring contacts are tin-alloy plated.

11. An electrical edge connector for receiving a printed circuit or wiring board comprising an insulating body with a board-receiving opening therein which contains an abutment for engagement by the board edge when fully inserted into the connector, characterised in that the abutment is adapted to restrain the board against movement thereof in directions other than that of withdrawal of the board from the connector.

12. An electrical edge connector as claimed in claim 11, characterised in that the abutment is provided with a V-shaped groove which receives the end of the printed board.

13. An electrical edge connector as claimed in claim 11, characterised in that the abutment is provided with semi-cylindrical groove which receives the end of the printed board.

14. A method of attaching to a printed circuit board/wiring board a plurality of contact pads having a convex profile in a direction in which the printed board is to be received by an edge connector, characterised in that the printed circuit board is provided with a plurality of conductive regions correspondingly dimensioned and shaped relative to the contact pads to be positioned thereon and in that the conductive regions are coated with a conductive bonding material which can be melted or otherwise treated when the contact pads are positioned thereon and thereafter resolidified to effect bonding of the contact pads to the board.

15. A method as claimed in claim 14, characterised in that the bonding material is solder which when melted produces precise self alignment of the approximately positioned contact pads with the underlying conductive regions prior to the re-solidification of the solder.

16. A method as claimed in claim 15, characterised in that the solder is contained in a solder paste.

17. A method as claimed in claim 16, characterised in that the solder paste is applied to appropriate points on the board by a silk screening process.

18. A method as claimed in any one of the claims 14 to 17, characterised in that contact pads are applied to the coated conductive regions by a "pick and place" mechanism.

19. An electrical connecting arrangement as claimed in any preceding claim, characterised in that the contact pads are attached to the printed circuit board by any of the methods according to claims 14 through to 18.

# Fig. 1.

Fig. 2.

*Fig. 3.*

Fig. 4.

# Fig. 5.

*Fig. 7(c)*

20  21

*Fig. 7(d)*

20  21

*Fig. 6.*

28

27

26

25

24

Fig. 7(a)

Fig. 7(b)

EP 0 414 393 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | GB-A-2179578 (BICC) <br> * abstract; figures 3, 4 * | 1 | H01R23/70 |
| X | FR-A-2460552 (BUNKER RAMO CORP.) <br> * page 2, lines 22 - 30; figure 1A * | 11 | |
| Y | | 12 | |
| Y | IBM TECHNICAL DISCLOSURE BULLETIN. <br> vol. 25, no. 3B, August 82, NEW YORK US <br> pages 1410 - 1411; CHIRINO ET AL.: <br> "SEMI-AUTOMATIC CARD INSERTION DEVICE" <br> * the whole document * | 12 | |
| X | FEINWERKTECHNIK + MESSTECHNIK. <br> no. 5, July 87, MÜNCHEN DE <br> pages 323 - 324; CZESCHKA ET AL.: <br> "STECKVERBINDER FÜR OBERFLÄCHENMONTAGE (SMT)" <br> * figure 2 * | 11 | |
| X | EP-A-250045 (E.I. DU PONT DE NEMOURS AND COMPANY) <br> * the whole document * | 14-19 | **TECHNICAL FIELDS SEARCHED (Int. Cl.5)** <br><br> H01R <br> H05K |

The present search report has been drawn up for all claims

| Place of search | Date of completion of the search | Examiner |
|---|---|---|
| BERLIN | 27 NOVEMBER 1990 | CLOSA, D |

EPO FORM 1503 03.82 (P0401)